# EUROPEAN PATENT APPLICATION

(11) **EP 2 738 805 A1**
(43) Date of publication of application: **04.06.2014**
(21) Application number: 13193402.8
(22) Date of filing: 19.11.2013
(51) Int. Cl.: H01L 23/49, H01L 21/60, C22C 21/00, H01L 23/00, C22C 21/02, C22C 21/06

(54) **Aluminium bonding wire, connection structure, semiconductor device and manufacturing method of same**

(30) Priority: 30.11.2012 JP 2012261927; 31.10.2013 JP 2013226459
(71) Applicant: Nippon Piston Ring Co., Ltd., Saitama-City, Saitama 338-8503 (JP); Ibaraki University, Ibaraki 310-8512 (JP)
(72) Inventor: Fujii, Yoshitaka, Saitama City, Saitama 338-8503 (JP); Yamamoto, Atsushi, Saitama City, Saitama 338-8503 (JP); Takeguchi, Shunsuke, Saitama City, Saitama 338-8503 (JP); Ishikawa, Yoshiki, Saitama City, Saitama 338-8503 (JP); Onuki, Jin, Hitachi-shi, Ibaraki 316-8511 (JP)
(74) Representative: TBK

(57) **Abstract**

The generation and propagation of cracks in a connection to a connected member is prevented. A semiconductor device is provided with a connection structure 15 between a bonding wire 17 consisting of an aluminum alloy which contains at least magnesium and silicon and in which a total of contents of the magnesium and the silicon is not less than 0.03 wt% but not more than 0.3 wt% and a silicon chip 16 to which this bonding wire 17 is connected. An aluminum-silicon film 16a is formed on the surface of the silicon chip 16. This connection structure 15 has a compound 18 containing magnesium and silicon in a matrix layer 17a constituting the bonding wire 17, in a fine grain layer 17b of the aluminum alloy formed between the matrix layer 17a and the aluminum-silicon film 16a, and at an interface between the matrix layer 17a and the fine grain layer 17b.

## Description

### BACKGROUND OF THE INVENTION

### Field of the Invention

The present invention relates to a bonding wire and a connection structure suitable for a power semiconductor, a semiconductor device provided with these, and a manufacturing method thereof.

### Description of the Related Art

A Si device which is a kind of a semiconductor is used as a discrete element such as a diode, a transistor and a thyristor, and as an integrated circuit such as a microcomputer, a memory and a communication device.

In a microcomputer and a memory, a Si device works for computation and memorization. On the other hand, there is a Si device called a power semiconductor and is used in power control. Thanks to a power semiconductor, rectification, frequency conversion, boosting and back-boosting and the like are possible. For example, a power semiconductor is used in various uses, such as driving of a motor and charging of a battery. For the kinds of power semiconductors, there are a power MOSFET (metal-oxide-semiconductor field-effect transistor), an IGBT (insulated gate bipolar transistor), a power bipolar transistor, a thyristor and the like. Among these power semiconductors, an IGBT is widely used in the market because of a large device capacity and a large range of adaptable operating frequency, excellent cost performance and the like.

In many cases, an IGBT is industrially used as a module structure in which a plurality of silicon chips are connected in parallel. Although the amount of a current flowing in one silicon chip is on the order of 100 A maximum, it is possible to handle a large current by adopting a module structure. Such an IGBT is used in a power generator using wind force, sunlight and the like, an industrial robot, an inverter in an automobile or an electric train, and the like. In recent years, due to an increase in hybrid vehicles (HV) and electric vehicles, the frequency of uses in automobiles has increased.

For an IGBT used in an automobile, the temperature warranty standard has become severe. Although a 120°C warranty has hitherto been general, at present a 150°C warranty is general and it is expected that the temperature warranty will be severer in the future. However, in an automobile in which a plurality of parts are densely arranged in a narrow space, the downsizing of an IGBT is demanded and it has become difficult to satisfy the temperature warranty standard which becomes severe because of an increase in heating value due to downsizing (refer to Patent Document 1, for example).

### [Citation List]

### [Patent Literature]

[Patent Literature 1] Japanese Patent Laid-Open No. 2008-311383 (refer to paragraph [0003])

### SUMMARY OF THE INVENTION

Breakages of an IGBT due to heat generation are divided into those caused by the deterioration of solder connections between a copper plate functioning as a heat sink and a ceramic substrate on which silicon chips are placed and those caused by the deterioration of the silicon chips and bonding wire connections. The deterioration of the bonding wire connections is due to thermal stresses generated by the repetition of the heating and cooling during operation of a power module, and this is the result of the propagation of cracks, which occur due to a difference in the coefficient of linear expansion between the bonding wire and the silicon chips, in the vicinity of an interface.

In an IGBT having a module structure in which a plurality of silicon chips are connected, in the case where wire breaking occurs due to the deterioration of a bonding wire in one place, the current flowing through the bonding wire flows to another bonding wire. In the other bonding wire, the heating value increases due to an increase in the flowing current and hence the deterioration proceeds at an accelerated pace and eventually wire breaking occurs in a chain reaction.

Therefore, in order to satisfy the temperature warranty standard which becomes severer, it is effective to prevent the generation and propagation of cracks in a connection between a bonding wire and a connected member, such as a silicon chip, and to improve the heat resistance cycle characteristics.

In addition, it is also effective to enhance a strength of the bonding wire; however, in this case, upon bonding, there is a possibility such that the connected member such as a silicon chip and the like is broken. It is true that it is possible to manufacture a semiconductor device without breaking the connected member since the bonding wire can be temporarily softened by being bonded at a high temperature; however, this is problematic in that oxidation occurs from heat and a productivity becomes low and the like.

The present invention was made in order to solve the above-described problem, and the object of the invention is to provide a bonding wire which prevents the generation and propagation of cracks without breaking a connected member upon bonding in a connection to the connected member, a connection structure of the bonding wire, a semiconductor device provided with these and a manufacturing method of the semiconductor device.

(1) The present invention provides a bonding wire characterized in consisting of an aluminum alloy which contains at least magnesium and silicon and in that a total of contents of the magnesium and the silicon is not less than 0.03 wt% but not more than 0.3 wt%.

According to the present invention, the connected member is not broken due to hardness of the bonding wire upon bonding as the bonding wire does not become so hard. In addition, the generation of cracks is prevented by the solid-solution hardening by magnesium and silicon. Furthermore, in the case in which, for example, Mg₂Si (called magnesium silicide) precipitates within the bonding wire by subjecting a bonding wire to aging treatment, a compound consisting of magnesium and silicon, the precipitation hardening by this compound prevents the propagation of cracks even when the cracks are generated in a connection to a connected member. Further, depending on the content ratio and the like, magnesium silicide may sometimes merely solid-dissolves in an aluminum alloy but not precipitate.

(2) The present invention also provides the bonding wire in (1) above characterized in that said aluminum alloy contains at least one of copper not less than 0.03 wt% but not more than 0.3 wt% and nickel not less than 0.001 wt% but not more than 0.02 wt%.

According to the above-mentioned invention, in the case in which an aluminum alloy contains copper not less than 0.03 wt% but not more than 0.3 wt%, the hardness of the bonding wire is further enhanced because Al₂Cu particles and Al₂CuMg particles and the like precipitate. In addition, in the case in which an aluminum alloy contains nickel not less than 0. 001 wt% but not more than 0.02 wt%, a humidity resistance is improved.

(3) The present invention also provides the bonding wire in (1) or (2) above characterized in that all or a part of said magnesium and said silicon precipitate as magnesium silicide, and said magnesium silicide precipitate not less than 0.1% but not more than 10% in terms of the area ratio of a radial cross section.

(4) The present invention also provides a connection structure characterized in being a connection structure between the bonding wire in any of (1) to (3) above and a connected member to which the bonding wire is connected and which consists of an aluminum material, and in that a compound containing magnesium and silicon precipitates in a matrix layer constituting the bonding wire, in a fine grain layer of the aluminum alloy formed between the matrix layer and the connected member, and at an interface between the matrix layer and the fine grain layer.

According to the above-described invention, the generation of cracks is prevented by the solid-solution hardening and precipitation hardening by the magnesium and silicon contained in the bonding wire consisting of an aluminum alloy. Furthermore, thanks to the precipitation hardening by a compound, in the case where a crack is generated in a connection to a connected member, the propagation of the crack is prevented.

(5) The present invention also provides the connection structure in (4) above characterized in that the compound contains aluminum.

(6) The present invention also provides a semiconductor device characterized in having the connection structure in any of (4) or (5) above.

(7) The present invention also provides a method of manufacturing the semiconductor device according to (6) above characterized in that after the bonding wire is connected to the connected member, the bonding wire is subjected to aging treatment.

According to the bonding wire in any of (1) to (3) above, the connection structure in any of (4) or (5) above, the semiconductor device in (6) above, and the method of manufacturing the semiconductor device in (7) above, it is possible to prevent the generation and propagation of cracks without breaking a connected member upon bonding in a connection to the connected member.

### BRIEF DESCRIPTION OF THE DRAWINGS

Figure 1 is an appearance perspective view of a semiconductor device of the present invention;
Figure 2 is a sectional view of the main part of the semiconductor device shown in Figure 1;
Figure 3(A) is a sectional view of an example of a connection structure provided in the semiconductor device shown in Figure 1; Figure 3(B) is a picture obtained by photographing sections at the interface between a matrix layer and a fine grain layer shown in Figure 3(A);
Figure 4 (A) is a graph showing the shearing strength in the connection structure shown in Figure 3(A), with the heating and cooling cycle number on the abscissa and the shearing strength on the ordinate;
Figure 4 (B) is a graph showing the shearing strength in the connection structure shown in Figure 3(A) as same as Figure 4(A).
Figure 5 (A) is a graph showing the deterioration rate of shearing strength in the connection structure shown in Figure 3(A), with the heating and cooling cycle number on the abscissa and the deterioration rate of shearing strength on the ordinate.
Figure 5 (B) is a graph showing the degradation rate of shearing strength in the connection structure shown in Figure 3(A) as same as Figure 5(A).
Figure 6 is a graph showing the deterioration rate of shearing strength and the generation degree of bonding damage in the connection structure shown in Figure 3(A), with the addition amount of magnesium silicide on the abscissa and the deterioration rate of shearing strength and the generation degree of bonding damage on the ordinate.

### DETAILED DESCRIPTION OF THE PREFERRED EMBODIMENTS

Referring to the drawings, a detailed description will be given below of a semiconductor device 10 of the present invention.

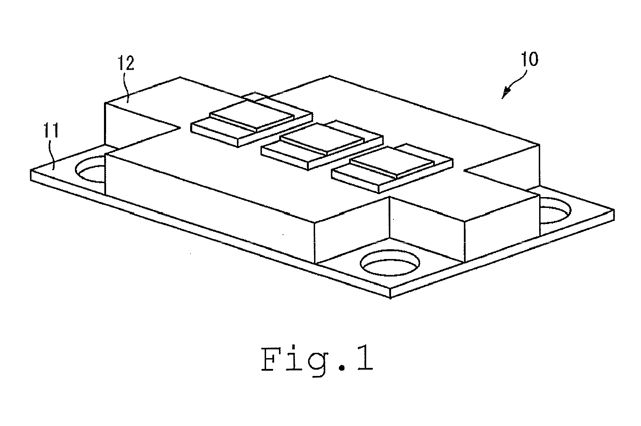

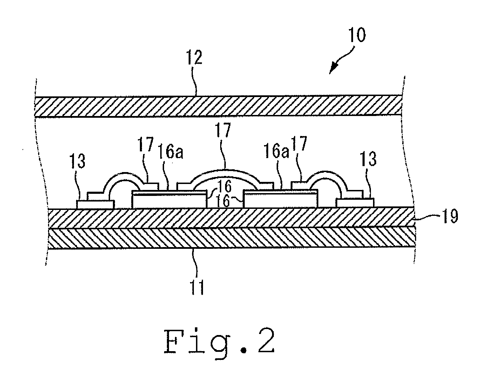

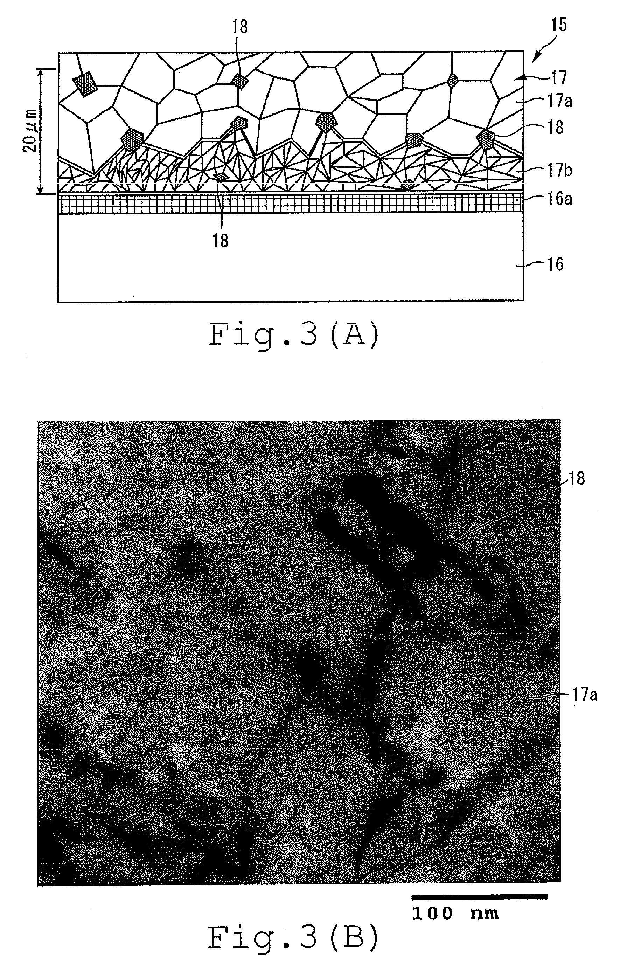

First, the configuration of the semiconductor device 10 will be described with the aid of Figure 1 to Figures 3(A) to 3(B). Figure 1 is an appearance perspective view of the semiconductor device 10. Figure 2 is a sectional view of the main part of the semiconductor device 10. Figure 3(A) is a sectional view of an example of a connection structure 15. Figure 3(B) is a picture obtained by photographing a section at the interface between a matrix layer 17a and a fine grain layer 17b. Further, the connection structure 15 shown in Figure 3(A) shows the case of a bonding wire 17 of which diameter is 300pm.

The semiconductor device 10 shown in Figures 1 and 2 is an IGBT module, which is a kind of power semiconductor. This semiconductor device 10 is mounted on a hybrid car and the like and is used in the control of electric power.

The semiconductor device 10 is provided with a copper plate (a Cu plate) 11 which functions as a heat sink, a ceramics substrate 19 arranged on this copper plate 11, an enclosure 12 made of resin and the like. In the interior of the enclosure 12, there are arranged a plurality of circuit layers 13, a plurality of silicon chips (Si chips) 16, a plurality of bonding wires 17 which are arranged between these plurality of silicon chips 16 or between the silicon chip 16 and the circuit layer 13. The circuit layers 13 and the silicon chips 16 function as connected members to which the bonding wires 17 are connected. Incidentally, an aluminum electrode pad 16a is deposited on the silicon chip 16. The bonding wire 17 is joined to the aluminum electrode pad 16a deposited on the silicon chip 16.

The bonding wire 17 is made of an aluminum (Al) alloy. The aluminum alloy contains at least magnesium (Mg) and silicon and it is preferred that a total of contents of the magnesium and the silicon be not less than 0.03 wt% but not more than 0.3 wt%. It is more preferred that the total be not less than 0.05 wt% but not more than 0.3 wt%. It is still more preferred that the total be not less than 0.05 wt% but not more than 0.2 wt%.

The reason why it is preferred that the total content of magnesium and silicon be not less than 0.03 wt% is that if the total content of magnesium and silicon is less than this value, in the first place, it is impossible to obtain the hardness of the aluminum alloy. The reason why it is preferred that the total content of magnesium and silicon be not more than 0.3wt% is that if the total content of magnesium and silicon exceeds this value, the aluminum alloy becomes too hard, with the result that in connecting the bonding wire 17 to the silicon chip 16 via the aluminum electrode pad 16a, the silicon chip 16 is damaged due to the hardness of the bonding wire 17.

All or a part of magnesium and silicon precipitate as magnesium silicide (Mg₂Si). The precipitation amount is preferably not less than 0.1% but not more than 10% in terms of the area ratio of a radial cross section of the bonding wire 17, and more preferably, it is not less than 0.5% but not more than 10%. In the case in which this area ratio is more than 10 %, the bonding wire 17 becomes hard, making it difficult to bond it at a room temperature. In addition, in the case in which this area ratio is less than 0.1 %, there is a possibility such that, when a crack is generated in the connection of the bonding wire 17 to the silicon chip 16, the propagation of this crack cannot be prevented.

The bonding wire 17 is for use in power semiconductors and has a prescribed diameter. It is preferred that the diameter of the bonding wire 17 be not less than 10 µm but not more than 500 µm. Preferably, this diameter is not less than 100 µm but not more than 500 µm.

The bonding wire 17 is of a type for use in bonding at ordinary temperature of not more than 60°C, it is preferred that the bonding wire 17 have hardness of not more than 35 Hmv (Vickers hardness) before aging treatment or during aging treatment, and the bonding wire 17 is hardened by aging treatment before or after bonding. Also, the bonding wire 17 is of a type for use in bonding at high temperatures of not less than 130°C but not more than 220°C, it is preferred that the bonding wire 17 have hardness of not more than 45 Hmv at ordinary temperature before aging treatment or during aging treatment and hardness of not more than 35 Hmv (Vickers hardness) at high temperatures, and the bonding wire 17 is hardened by aging treatment before or after bonding.

Reference numeral 15 in Figure 3(A) denotes a connection structure between the silicon chip 16 and the bonding wire 17. In this connection structure 15, the bonding wire 17 is joined to the silicon chip 16. An ultrasonic joining technology which involves applying ultrasonic oscillations is used in joining the bonding wire 17. After joining, aging treatment whose treatment temperature is ordinary temperature to 300°C is performed.

The silicon chip 16 is such that on the surface thereof there is formed an aluminum-silicon film 16a made of an aluminum material which functions as an aluminum electrode pad. The bonding wire 17 has a matrix layer 17a and a fine grain layer 17b of aluminum alloy which is formed between this matrix layer 17a and the silicon film 16a. This fine grain layer 17b is formed by the recrystallization of a strained area occurring during ultrasonic joining. A compound 18 containing magnesium and silicon is formed in the matrix layer 17a, in the fine grain layer 17b, and at an interface between the matrix layer 17a and the fine grain layer 17b. Specifically, in a prescribed range from the interface of the fine grain layer 17b (upward in Figure 3(A)) to the aluminum-silicon film 16a there is formed the compound 18 containing magnesium and silicon. This compound 18 precipitates due to aging treatment. Incidentally, because in the range of 20 µm in the direction of the bonding wire 17 from the interface of the fine grain layer 17b to the aluminum-silicon film 16a, the compound 18 precipitates in amounts of not less than 0.1% in terms of the area ratio in a section in the direction of the interface between the fine grain layer 17b and the aluminum-silicon film 16a (in the horizontal direction in Figure 3(A)), even in the case where a crack is generated in the connection of the bonding wire 17 to the silicon chip 16, the propagation of this crack is prevented. Incidentally, for the shape of actual compounds 18, see the photograph shown in Figure 3(B). This photograph is taken at 30, 000 magnification and at a visual area of 400nm × 400nm and shows the bonding wire 17 made of an aluminum alloy containing 0.3 wt% of magnesium silicide. Further, the bonding wire 17 shown by this photograph is made into one of objects of Experiment 3 to be described later.

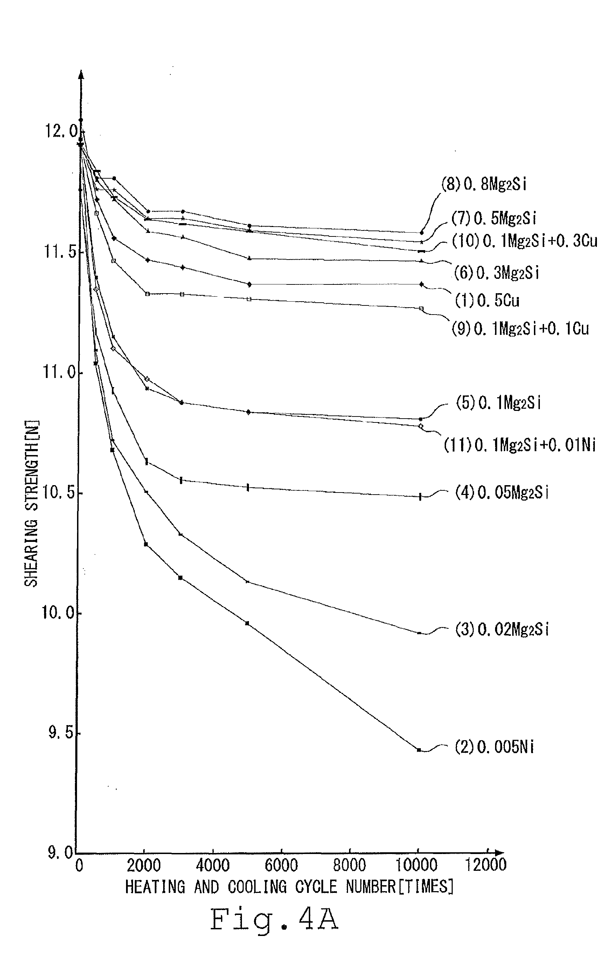

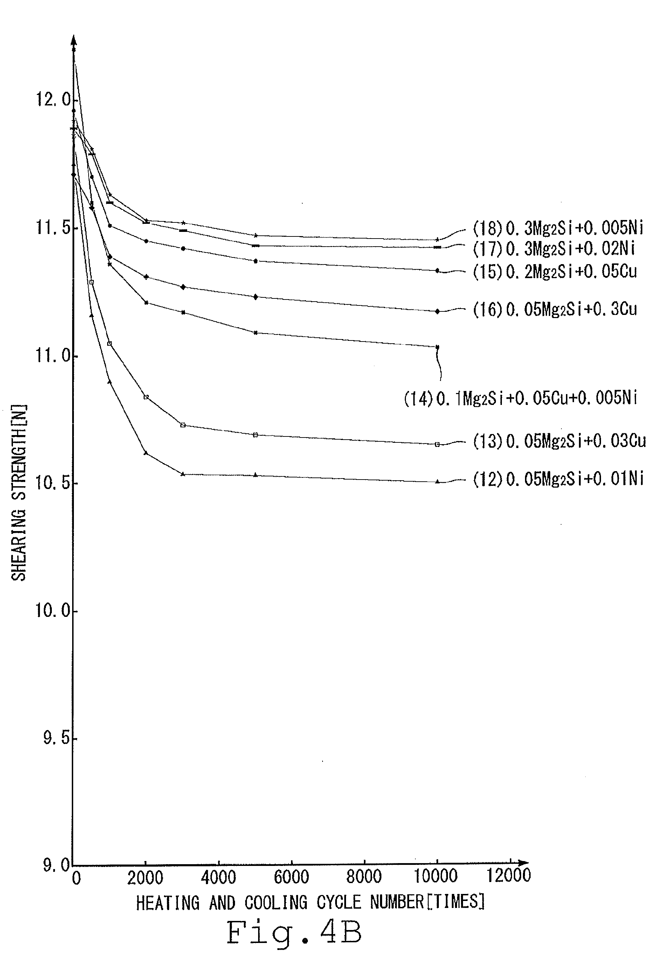

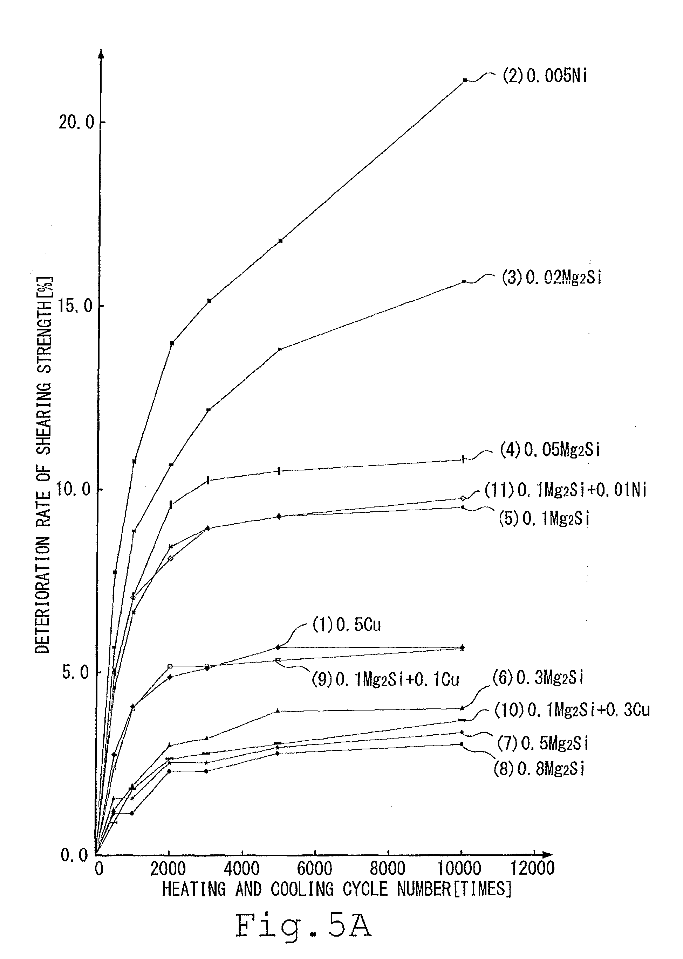

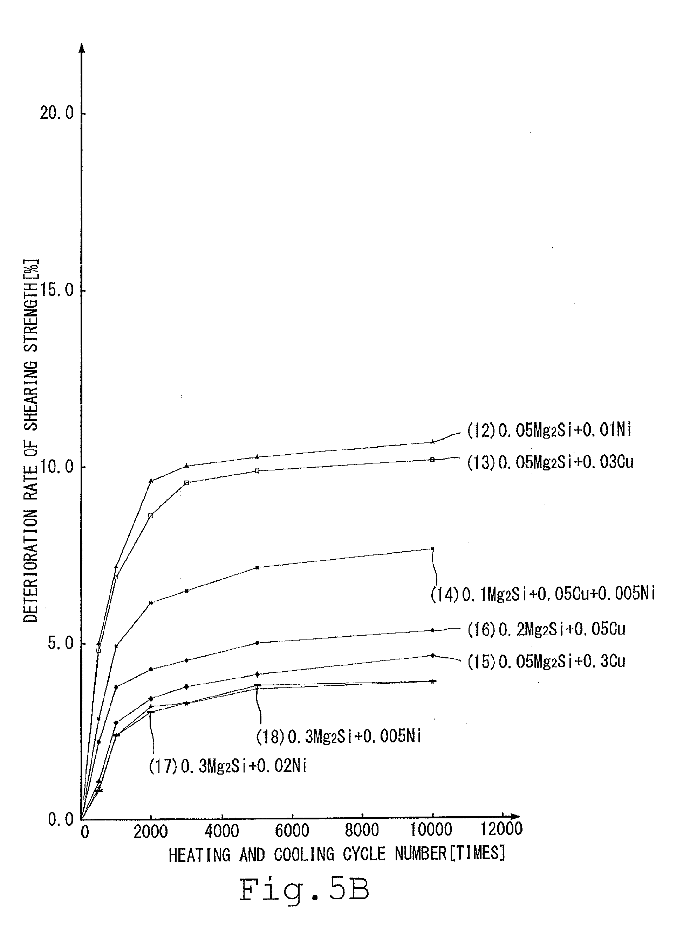

[Experiment 1] Next, Experiment 1 conducted to investigate the shearing strength of various kinds of aluminum alloys will be described with the aid of Figures 4(A), 4 (B) and Figures 5(A), 5(B). Figures 4(A) and 4(B) are graphs showing the shearing strength in the connection structure 15, with the heating and cooling cycle number [times] on the abscissa and shearing strength [N] on the ordinate. Shearing strength refers to a maximum shearing force under which the material constituting the connection structure 15 can withstand without a break. Figures 5 (A) and 5 (B) are graphs showing the deterioration rate of shearing strength in the connection structure 15, with the heating and cooling cycle number [times] on the abscissa and the deterioration rate of shearing strength [%] on the ordinate. The deterioration rate of shearing strength refers to a value which indicates by percentage the degree of deterioration based on the case where the heating and cooling cycle number is 0 times. Incidentally, in Figures 4(A), 4(B) and Figures 5(A), 5(B), each plot shown in the graphs is an average value obtained by conducting the experiment 16 times. The shearing strength of various kinds of aluminum alloys was investigated at room temperature.

In Experiment 1, repetitions of heat generation and cooling by the use of the semiconductor device 10 were created in a simulated manner. One heating and cooling cycle has a heating step for heating from 70°C to 120°C in 100 seconds and a cooling step for cooling from 120°C to 70°C in 70 seconds immediately thereafter. Each heating and cooling cycle was repeated without an interval.

For (1) an aluminum alloy containing 0.5 wt% of copper, (2) an aluminum alloy containing 0. 005 wt% of nickel, (3) an aluminumalloy containing 0.02 wt% of magnesium silicide, (4) an aluminum alloy containing 0.05 wt% of magnesium silicide, (5) an aluminum alloy containing 0 .1 wt% of magnesium silicide, (6) an aluminum alloy containing 0.3 wt% of magnesium silicide , (7) an aluminum alloy containing 0.5 wt% of magnesium silicide, (8) an aluminum alloy containing 0.8 wt% of magnesium silicide, (9) an aluminum alloy containing 0.1 wt% of magnesium silicide and 0.1 wt% of copper, (10) an aluminum alloy containing 0.1 wt% of magnesium silicide and 0.3 wt% of copper, (11) an aluminum alloy containing 0.1 wt% of magnesium silicide and 0.01 wt% of nickel, (12) an aluminum alloy containing 0.05 wt% of magnesium silicide and 0.01 wt% of nickel, (13) an aluminum alloy containing 0.05 wt% of magnesium silicide and 0.03 wt% of copper, (14) an aluminum alloy containing 0.1 wt% of magnesium silicide, 0.05 wt% of copper and 0.005 wt% of nickel, (15) an aluminum alloy containing 0.2 wt% of magnesium silicide and 0.05 wt% of copper, (16) an aluminum alloy containing 0.05 wt% of magnesium silicide and 0.3 wt% of copper, (17) an aluminum alloy containing 0.3 wt% of magnesium silicide and 0.02 wt% of nickel, and (18) an aluminum alloy containing 0. 3 wt% of magnesium silicide and 0. 005 wt% of nickel, the investigation was conducted in each of the cases where the heating and cooling cycle number is 0 times, 500 times, 1000 times, 2000 times, 3000 times, 5000 times, and 10000 times. Incidentally, each aluminum alloy was subjected to aging treatment beforehand.

As shown in Figure 4(A) and Figure 5(A), in each of (4) to (8) the aluminum alloys containing not less than 0.05 wt% but not more than 0.8 wt% of magnesium silicide, the deterioration rate of shearing strength by the heating and cooling cycle, of which heating and cooling cycle number is 10000 times, became not more than 10%, which is less than 1/2 of that of (2) the aluminum alloy containing 0.005 wt% of nickel. Among them, in each of (6) to (8) the aluminum alloys containing not less than 0.3 wt% but not more than 0.8 wt% of magnesium silicide, the deterioration rate of shearing strength by the heating and cooling cycle where heating and cooling cycle number is 10000 times became not more than 4%, which is lower than that of (1) the aluminum alloy containing 0.5 wt% of copper. On the other hand, the deterioration rate of shearing strength by the heating and cooling cycle, of which heating and cooling cycle number is 10000 times, of (3) the aluminum alloy containing 0.02 wt% of magnesium silicide became 15%.

Furthermore, the deterioration rate of shearing strength of (9) the aluminum alloy containing 0.1 wt% of magnesium silicide and 0.1 wt% of copper became comparable to that of (1) the aluminum alloy containing 0.5 wt% of copper. In addition, the deterioration rate of shearing strength by the heating and cooling cycle, of which heating and cooling cycle number is 10000 times, of (10) the aluminum alloy containing 0.1 wt% of magnesium silicide and 0.3 wt% of copper became 3.7%, which is lower than that of (1) the aluminum alloy containing 0.5 wt% of copper.

Further, the deterioration rate of shearing strength of (11) the aluminum alloy containing 0.1 wt% of magnesium silicide and 0.01 wt% of nickel became comparable to that of (5) the aluminum alloy containing 0.1 wt% of magnesium silicide.

Subsequently, in each of (1) the aluminum alloy containing 0.5 wt% of copper, (4) to (8)the aluminum alloys containing not less than 0.05 wt% but not more than 0.8 wt% of magnesium silicide, (9) to (10) the aluminum alloys containing 0.1 wt% of magnesium silicide and not less than 0.1 wt% but not more than 0.3 wt% of copper, and (11) the aluminum alloy containing 0.1 wt% of magnesium silicide and 0.01 wt% of nickel, the deterioration rate of shearing strength became approximately constant within the range of the heating and cooling cycle, of which heating and cooling cycle number is not less than 2000 times but not more than 10000 times.

On the other hand, in each of (2) the aluminum alloy containing 0.005 wt% of nickel and (3) the aluminum alloy containing 0.02 wt% of magnesium silicide, the shearing strength decreased with increasing heating and cooling cycle number, that is, the deterioration rate of shearing strength increased.

As shown in Figs. 4(B) and 5(B), in each of (12) to (18) the aluminum alloys containing not less than 0.05 wt% but not more than 0.3 wt% of magnesium silicide, further containing not less than 0.03 wt% but not more than 0.3 wt% of copper, or not less than 0.005 wt% but not more than 0.02 wt% of nickel, the deterioration rate of shearing strength by the heating and cooling cycle, of which heating and cooling cycle number is 10000 times, became not more than 10%, and became approximately constant within the range of the heating and cooling cycle, of which heating and cooling cycle number is not less than 2000 times but not more than 10000 times.

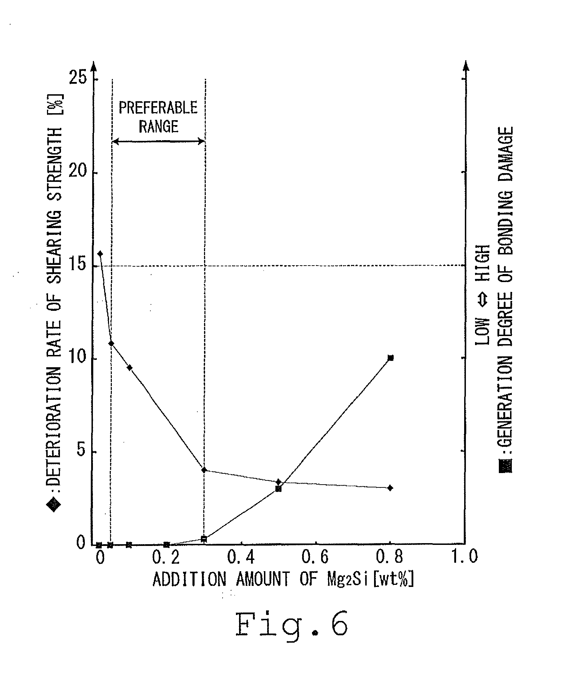

[Experiment 2] Next, Experiment 2 conducted to investigate the shearing strength and the generation degree of bonding damage (i.e. a fraction defective) of various kinds of aluminum alloys will be described with the aid of Figure 6. Figure 6 is a graph showing the deterioration rate of shearing strength and the generation degree of bonding damage in the connection structure 15, with the addition amount of magnesium silicide [wt%] on the abscissa, the deterioration rate of shearing strength [%] and the generation degree of bonding damage on the ordinate.

The data obtained in Experiment 1 is used as the data necessary for Experiment 2. That is, repetitions of heat generation and heat dissipation due to the use of the semiconductor device 10 were created in a simulated manner. One heating and cooling cycle has a heating step for heating from 70°C to 120°C in 100 seconds and a cooling step for cooling from 120°C to 70°C in 70 seconds immediately thereafter. Each heating and cooling cycle was repeated 10000 times without an interval. The shearing strength of various kinds of aluminum alloys was investigated at room temperature.

The investigation was conducted in each of the cases where the addition amount of magnesium silicide is 0.02 wt%, 0.05 wt%, 0.1 wt%, 0.2 wt%, 0.3 wt%, 0.5 wt%, and 0.8 wt%.

The more the addition amount of magnesium silicide is increased, the more the deterioration rate of shearing strength is decreased, allowing the deterioration rate of shearing strength to be not more than 15%, as shown in Figure 6, at not less than 0. 03 wt% of the addition amount of magnesium silicide.

In addition, the more the addition amount of magnesium silicide is increased, the more the generation degree of bonding damage is increased, allowing the generation degree of bonding damage to be rapidly high when the addition amount of magnesium silicide exceeds 0.3 wt%.

It is when the addition amount of magnesium silicide is located within not less than 0.03 wt% but not more than 0.3 wt% that both of these deterioration rate of shearing strength and generation degree of bonding damage have good evaluations.

As described above, according to the semiconductor device 10, the generation of cracks in the bonding wire 17 is prevented by the solid-solution hardening by the magnesium and silicon contained in the bonding wire 17. Furthermore, even when a crack is generated in a connection of the bonding wire 17 to the silicon chip 16, the propagation of the crack is prevented by the precipitation hardening of the compound 18 in the case of the compound 18 precipitates at an interface between the fine grain layer 17b and the aluminum-silicon film 16a. Further, depending on the content ratio and the like, magnesiumsilicidemay sometimes merely solid-dissolves in an aluminum alloy but not precipitate.

Furthermore, because the hardness of the bonding wire 17 has not reached a maximum hardness, in connecting the bonding wire 17 to the silicon chip 16, the silicon chip 16 is prevented from being damaged due to the hardness of the bonding wire 17. During the use of the semiconductor device 10, the aging hardening of the bonding wire 17 due to heat generation proceeds further. As a result of this, an improvement in the operation life of the connection structure 15 is further achieved.

[Experiment 3] Next, Experiment 3 conducted to investigate the precipitation amount, the electric resistance, and Vickers hardness of the compound 18 (magnesium silicide) with respect to an aluminum alloy containing magnesium silicide will be described with the aid of Table 1. Table 1 shows the measured values and the evaluation results in the case in which the content rate of magnesium silicide is changed.

In the present experiment 3, with respect to the compound 18, measurement of the precipitation amount, evaluation of the electric resistance, and measurement of Vickers hardness were conducted in series.

The measurement of the precipitation amount of the compound 18 was carried out by observing the cross section of the bonding wire 17 at 30,000 magnification via a transmission electron microscope (TEM), taking a picture of the vicinity of a joined interface, and binarizing digital images (refer to Figure 3(B)). Subsequently, the area ratios of magnesium silicide at ten visual areas of 400 nm × 400 nm were measured to take the average thereof.

The evaluation of the electric resistance of the compound 18 was carried out by measuring the electric resistance value thereof and comparing it with the electric resistance value of the aluminum alloy without magnesium silicide (that is, an aluminum alloy containing 0.005 wt% of nickel). The measurement of the electric resistance value of the compound 18 was carried out by employing a direct current four-terminal method for the bonding wire 17, with a diameter of 0.3 mm and a gauge length of 1 m, at a tension of 15g and 20°C. The mΩ HiTESTER 3540 manufactured by HIOKI E. E. CORPORATION was used for the measurement.

The evaluation results of the electric resistance, of which increase ratio of the electric resistance value compared to the aluminum alloy without magnesium silicide is less than 15% (including minus increase ratio), was defined as "○", and the results with the increase ratio not less than 15% was defined as "×".

A sample for measurement of Vickers hardness was made by embedding a wire rod (bonding wire 17) with a length of 15 mm and a diameter of 0. 3 mm in a normal temperature hardening of epoxy resin and applying mirror polishing horizontally to a longitudinal direction of the wire rod. In addition, the sample was adjusted such that a tab for polishing became not less than 0. 14 mm but not more than 0.15 mm. The micro hardness testing machine, HM-211, manufactured by Mitutoyo Corporation was used for measurement with a load for a test of 0.9807N(=0.1kgf).

Respective cases that the addition amounts of magnesium silicide are 0.02 wt%, 0.03 wt%, 0.1 wt%, 0.3 wt%, and 0.35 wt% were respectively investigated.

**[Table 1]**

| | AREA RATIO OF Mg₂Si[%] | EVALUATION OF ELECTRIC RESISTANCE | HARDNESS H₂O.1 |
|---|---|---|---|
| 0.02Mg₂Si | 0 | ○ | 18 |
| 0.03Mg₂Si | 0.1 | ○ | 19 |
| 0.1Mg₂Si | 2.2 | ○ | 23 |
| 0.3Mg₂Si | 10.0 | ○ | 35 |
| 0.35Mg₂Si | 12.7 | × | 38 |

In this way, if the addition amounts of magnesium and silicon are increased in order to increase the precipitation amount of magnesium silicide that is effective to prevent the generation and propagation of cracks, the present bonding wire is not suitable for bonding as the value of Vickers hardness is increased. Subsequently, the value of the resistant value is increased to worsen the evaluation of the electric resistance. Therefore, it is preferable that the area ratio of magnesium silicide is not more than 10%. In other words, it is preferable that the addition amount of magnesium silicide is not more than 0.3 wt%. In addition, it is preferable that the addition amount of magnesium silicide is not less than 0.03 wt% in which magnesium silicide effective for preventing the generation and propagation of cracks precipitates.

The present invention is not limited to the above-described embodiment, and various kinds of variations are possible. For example, the present invention can be also applied to a bonding ribbon.

That is, in the above-described embodiment, the bonding wire 17 may contain not less than 0.03 wt% but not more than 0.3 wt% of copper or not less than 0.001 wt% but not more than 0.02 wt% of nickel. As for nickel, it is more preferable that the bonding wire 17 contains not less than 0.001 wt% but not more than 0.01 wt% of nickel. When copper is added, hardness is further improved. When nickel is added, humidity resistance is improved.

[Experiment 4] Next, Experiment 4 conducted to investigate humidity resistance of an aluminum alloy containing magnesium silicide and nickel will be described with the aid of Table 2. Table 2 shows the evaluation results in the case in which the content rate of nickel is changed.

The present experiment 4 was conducted under several conditions such as a temperature of 121 °C, a relative humidity RH of 100%, an atmosphere pressure of 2 atm, and then, a degradation degree after leaving the present aluminum alloy for 168 hours was measured. The bonding wire with a diameter of 0.3 mm was used. In this experiment 4, the wire became eroded and collapsed with time while a wire cross-sectional area became gradually small.

Respective cases that the addition amounts of nickel are 0 wt%, 0.0005 wt%, 0.001 wt%, 0.01 wt%, 0.02 wt% with the addition amount of magnesium silicide 0.1 wt% were investigated.

The evaluation results, of which humidity resistance is better compared to the bonding wire without nickel but with magnesium silicide of 0.1wt% added (theresults with the wire cross-sectional area after the experiment kept to be not less than 95% compared to the wire cross-sectional area before the experiment) was defined as "⊚", and the results considered to be ordinarily degraded similar to the conventional wires (the results with the wire cross-sectional area after the experiment kept to be not less than 90% but less than 95% compared to the wire cross-sectional area before the experiment) was defined as "○".

**[Table 2]**

| | EVALUATION OF HUMIDITY RESISTANCE |
|---|---|
| 0.1Mg₂Si | ○ |
| 0.1Mg₂Si+0.0005Ni | ○ |
| 0.1Mg₂Si+0.001Ni | ⊚ |
| 0.1MgsSi+0.01Ni | ⊚ |
| 0.1Mg₂Si+0.02Ni | ⊚ |

In this way, if nickel is added not less than 0. 001 wt%, a humidity resistance is improved. Subsequently, even if nickel is added 0.02 wt%, the evaluation results are not different from those with nickel of 0.01 wt% added. In the case in which a viewpoint of a cost is considered to be important, it is preferred to minimize the addition amount of typically-expensive nickel as much as possible. As described above, the addition amount nickel is preferably to be not less than 0.001 wt% but not more than 0.02 wt%, more preferably, not less than 0.001 wt% but not more than 0.01 wt%.

Alternatively, in the above-described embodiment, a wire before joining may sometimes be subjected to aging hardening until a maximum hardness, and also, there is the case where aging treatment is not performed before joining and aging hardening proceeds at a working temperature after joining.

Alternatively, in the above-described embodiment, as the semiconductor device 10, a general power module, a power MOS transistor, a diode module and the like or discrete types of these may be used in place of the IGBT module.

The generation and propagation of cracks in a connection to a connected member is prevented. A semiconductor device 10 is provided with a connection structure 15 between a bonding wire 17 consisting of an aluminum alloy which contains at least magnesium and silicon and in which a total of contents of the magnesium and the silicon is not less than 0.03 wt% but not more than 0.3 wt% and a silicon chip 16 to which this bonding wire 17 is connected. An aluminum-silicon film 16a is formed on the surface of the silicon chip 16. This connection structure 15 has a compound 18 containingmagnesium and silicon in a matrix layer 17a constituting the bonding wire 17, in a fine grain layer 17b of the aluminum alloy formed between the matrix layer 17a and the aluminum-silicon film 16a, and at an interface between the matrix layer 17a and the fine grain layer 17b.

## Claims

1. A bonding wire **characterized in** consisting of an aluminum alloy which contains at least magnesium and silicon and **in that** a total of contents of the magnesium and the silicon is not less than 0.03 wt% but not more than 0.3 wt%.

2. The bonding wire according to claim 1 **characterized in that** said aluminum alloy contains at least one of copper not less than 0.03 wt% but not more than 0.3 wt% and nickel not less than 0.001 wt% but not more than 0.02 wt%.

3. The bonding wire according to claim 1 or 2 **characterized in that** all or a part of said magnesium and said silicon precipitate as magnesium silicide, and said magnesium silicide precipitate not less than 0.1% but not more than 10% in terms of the area ratio of a radial cross section.

4. A connection structure **characterized in** being a connection structure between the bonding wire according to any of claims 1 to 3 and a connected member to which the bonding wire is connected and which consists of an aluminum material, and **in that** a compound containing magnesium and silicon precipitates in a matrix layer constituting the bonding wire, in a fine grain layer of the aluminum alloy formed between the matrix layer and the connected member, and at an interface between the matrix layer and the fine grain layer.

5. The connection structure according to claim 4 **characterized in that** the compound contains aluminum.

6. A semiconductor device **characterized in** having the connection structure according to claim 4 or 5.

7. A method of manufacturing the semiconductor device according to claim 6 **characterized in that** after the bonding wire is connected to the connected member, the bonding wire is subjected to aging treatment.
